(19) Europäisches Patentamt

European Patent Office

Office européen des brevets

(11) Veröffentlichungsnummer: **0 284 817**
**B1**

(12) **EUROPÄISCHE PATENTSCHRIFT**

(45) Veröffentlichungstag der Patentschrift: **23.01.91**

(21) Anmeldenummer: **88103342.7**

(22) Anmeldetag: **04.03.88**

(51) Int. Cl.[5]: **H 01 L 21/60**

(54) **Verfahren zum Herstellen von Halbleiterbauelementen.**

(30) Priorität: **03.04.87 CH 1288/87**

(43) Veröffentlichungstag der Anmeldung:
**05.10.88 Patentblatt 88/40**

(45) Bekanntmachung des Hinweises auf die
Patenterteilung:
**23.01.91 Patentblatt 91/04**

(84) Benannte Vertragsstaaten:
**CH DE FR GB IT LI NL**

(56) Entgegenhaltungen:
**EP-A-0 106 598**
**GB-A-1 328 185**
**US-A-4 098 452**
**US-A-4 358 784**

(73) Patentinhaber: **BBC Brown Boveri AG**
**Haselstrasse**
**CH-5401 Baden (CH)**

(72) Erfinder: **Kloucek, Franz, Dr.**
**Brückenstrasse 10**
**CH-5430 Wettingen (CH)**

## Beschreibung

### Technisches Gebiet

Die Erfindung bezieht sich auf das Gebiet der Halbleiter-Technologie. Sie betrifft speziell ein Verfahren zum Herstellen von Halbleiterbauelementen, insbesondere für höhere Leistungen, bei welchem Verfahren ein scheibenförmiges Halbleitersubstrat mit einer metallischen Kontaktscheibe stoffschlüssig verbunden wird und welches Verfahren die folgenden Schritte umfasst:

zwischen dem Halbleitersubstrat und der damit zu verbindenden Kontaktscheibe wird wenigstens eine Schicht aus einem Lot angeordnet, welches Lot mit dem Halbleitermaterial des Halbleitersubstrats eine eutektische Legierung bilden kann; und

die Schichtanordnung aus Kontaktscheibe, Lotschicht und Halbleitersubstrat wird auf eine Temperatur oberhalb der eutektischen Temperatur der Legierung aus Lot und Halbleitermaterial erwärmt.

### Stand der Technik

Bei der Herstellung von Leistungs-Halbleiterbauelementen werden die scheibenförmigen, meist grossflächigen Halbleitersubstrate beidseitig mit einer Kontaktanordnung versehen und in ein geeignetes Gehäuse eingebaut.

Die Kontaktanordnungen müssen mehrere Aufgaben erfüllen: Zum einen müssen sie die im Halbleitersubstrat bei Belastung entstehende Wärme effektiv abführen, d.h. eine gute Wärmeleitfähigkeit aufweisen. Zum anderen dienen sie gleichzeitig der Stromzuführung, d.h. auch die elektrische Leitfähigkeit muss gut sein. Schliesslich müssen die Kontaktanordnungen so gewählt sein, dass sich eine hohe Lastwechselfestigkeit des Bauelements ergibt, d.h. keine Ermüdungen durch Temperaturwechsel auftreten.

Es ist nun bekannt (siehe z.B. die DE-PS 29 17 165), bei einem Leistungs-Halbleiterbauelement die Kontaktanordnung zumindestens auf einer Seite des Halbleitersubstrats als sogenannten "Legierkontakt" aufzubauen. Hierzu wird das Substrat, in der Regel ein Si-Substrat, mittels eines Aluminiumlots mit einer Trägerelektrode oder Kontaktscheibe aus Mo oder W stoffschlüssig verbunden.

Das Lot wird dabei als Al-Folie zwischen Halbleitersubstrat und Kontaktscheibe gelegt und die entstehende Schichtanordnung auf 700°C bis 800°C erhitzt. Bei diesen Temperaturen schmilzt das Lot auf und bildet mit dem Si des angrenzenden Halbleitersubstrats eine Al-Si-Legierung, die ein Eutektikum mit einer eutektischen Temperatur von 577°C aufweist.

Bei den bisherigen Verfahren wurden zum Legieren entweder viele Bauelemente in einem Stapel angeordnet und in einem Vakuumofen langsam erwärmt oder die zu legierenden Schichtanordnungen einzeln in einem Durchlaufofen unter Schutzgasatmosphäre erwärmt.

Beiden Verfahren ist der Nachteil gemeinsam, dass, bedingt durch lange Verfahrenszyklen, inhomogene Temperaturverteilungen und hohe Temperaturen sich lokal erhebliche Mengen Si des Halbleitersubstrats bis in grössere Tiefen im Lot auflösen.

Dabei werden unter Umständen bei Leistungs-Halbleiterbauelementen mit flach eindiffundierten pn-Uebergängen, wie sie bei den GTO (Gate Turn Off)-Thyristoren anzutreffen sind, diese pn-Uebergänge zerstört, womit die Bauelemente funktionsunfähig werden.

Daneben führt die Schutzgasatmosphäre in Durchlauföfen zum vermehrten Auftreten von Bondfehlern, die z.B. in Form von Poren oder Rissen in der stoffschlüssigen Verbindung vorliegen und diese Verbindung schwächen.

### Darstellung der Erfindung

Aufgabe der vorliegenden Erfindung ist es nun, ein Verfahren zum Herstellen von Legierkontakten anzugeben, welches einerseits für die Serienfertigung geeignet ist, und andererseits das Aufschmelzen des Halbleitermaterials während des Legiervorgangs auf ein unkritisches Mass reduziert.

Die Aufgabe wird bei einem Verfahren der eingangs genannten Art dadurch gelöst, dass

die Erwärmung der Schichtanordnung einzeln durch Wärmestrahlung in einem Vakuum erfolgt, und

für die Erwärmung Flächenheizelemente verwendet werden, deren Fläche grösser ist als die Fläche der zu verbindenden Schichtanordnung.

Der Kern der Erfindung besteht darin, durch die Verwendung von grossflächigen Flächenheizelementen und Erwärmung der Schichtanordnung mittels Wärmestrahlung im Vakuum eine sehr homogene Temperaturverteilung zu schaffen, die gut geregelt und schnell gesteuert werden kann. Auf diese Weise können kurze Legierzeiten bei vergleichsweise niedrigen Legiertemperaturen eingehalten werden, so dass die Auflösung des Halbleitermaterials beim Legieren auf eine geringe Tiefe beschränkt bleibt und selbst flache pn-Uebergänge nicht gefährdet werden.

Gemäss einer bevorzugten Ausführungsform der Erfindung wird die Schichtanordnung zwischen zwei parallel angeordneten Flächenheizelementen, insbesondere in Form von stromdurchflossenen Graphitfolien, erwärmt, wobei die Fläche der stoffschlüssigen Verbindung zwischen dem Halbleitersubstrat und der Kontaktscheibe parallel zu den Flächen der Flächenheizelemente orientiert ist.

Bevorzugt besteht das Halbleitersubstrat aus Si, wird als Lot Al verwendet und besteht die Kontaktscheibe aus Mo oder W.

Weitere Ausgestaltungen der Erfindung ergeben sich aus den Unteransprüchen.

### Kurze Beschreibung der Zeichnungen

Die Erfindung soll nachfolgend im Zusammenhang mit der Zeichnung anhand von Ausführungsbeispielen näher erläutert werden.

Es zeigen:

Fig. 1 in schematisierter Schnittansicht die an sich bekannte Art des Einbaus eines Halbleiterbauelements für höhere Leistungen mit Legierkontakt;

Fig. 2 den Schnitt durch ein GTO-Bauelement mit Legierkontakt in einer Teilansicht;

Fig. 3 die schematische Anordnung zur Herstellung eines Legier kontaktes gemäss einem bevorzugten Ausführungsbeispiel der Erfindung;

Wege zur Ausführung der Erfindung

Die Erfindung wird nachfolgend, ohne Beschränkung der Allgemeinheit, am Beispiel eines anodenseitigen Legierkontaktes für einen Leistungs-GTO-Thyristor erläutert.

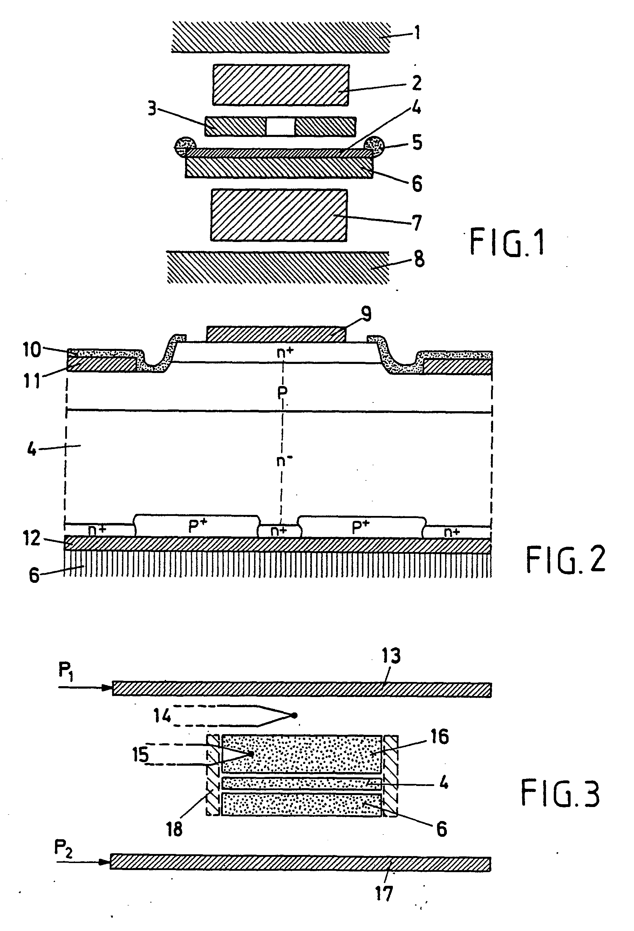

Das sogenannte "packaging", d.h. die Abfolge der verschiedenen Teile, die übereinander angeordnet das im Gehäuse eingebaute Bauelement ergeben, ist für einen solchen GTO-Thyristor schematisiert in Fig. 1 dargestellt.

Zentrales Element ist ein scheibenförmiges, üblicherweise rundes Halbleitersubstrat 4, welches im Inneren eine Folge geeignet dotierter Schichten aufweist, einen Durchmesser in der Grössenordnung von 10... 100 mm und eine Dicke in der Grössenordnung von 0,3... 0,5 mm hat.

Das Halbleitersubstrat 4, das nahezu ausschliesslich aus Si besteht, ist durch Anlegieren stoffschlüssig mit einer Kontaktscheibe 6 verbunden (üblicherweise aus Mo oder W). Am Rande des Halbleitersubstrats 4 ist eine Randpassivierung 5 vorgesehen, welche die Sperrspannungsfestigkeit des Bauelements erhöhen soll.

Auf der dem Legierkontakt gegenüberliegenden Seite wird das Halbleitersubstrat 4 durch eine weitere, aufliegende Kontaktscheibe 3, ebenfalls aus Mo oder W, kontaktiert.

Der Stapel aus Halbleitersubstrat 4 und beiden Kontaktscheiben 3, 6 liegt seinerseits zwischen zwei Ausgleichsscheiben 2, 7 (meist aus Cu), die den thermischen Kontakt zu den aussen angeordneten Kühlkörpern 1, 8 herstellen (anders als in der Darstellung der Fig. 1 steht beim zusammengebauten Bauelement der ganze Stapel in Presskontakt).

Der Legierkontakt aus Halbleitersubstrat 4 und Kontaktscheibe 6 beschränkt sich bei einem GTO-Thyristor.auf die Anodenseite, da die Kathode mit einer isolierenden Polyimdschicht versehen werden muss, wie dies aus Fig. 2 ersichtlich ist.

Fig. 2 zeigt in Teilansicht den Querschnitt durch das Halbleitersubstrat 4 eines GTO-Thyristors mit Legierkontakt. Das Halbleitersubstrat 4 enthält von der Kathode (oben) zur Anode (unten) eine Mehrzahl abwechselnd dotierter Schichten, von denen die beiden oberen ($n^+$-Emitter und p-Basis) auf der Kathodenseite mit einem Kathodenkontakt 9 und Gatekontakten 11 versehen sind. Die Gatekontakte 11 sind mit der bereits erwähnten Isolierschicht 10 aus Polyimid abgedeckt.

Auf der Anodenseite ist das Halbleitersubstrat 4 mit der Mo-Kontaktscheibe 6 durch eine Uebergangsschicht 12 (Al-Si-Legierung) stoffschlüssig verbunden. Die auf der Anodenseite eindiffundierten pn-Uebergänge haben nur eine Tiefe von einigen μm, so dass die Schwierigkeit beim Herstellen eines derartigen Legierkontaktes darin besteht, das In-Lösung-gehen des Si-Halbleitermaterials während des Legiervorgangs auf eine Tiefe zu beschränken, die deutlich unterhalb der Tiefe der pn-Uebergänge liegt.

Dies wird beim erfindungsgemässen Verfahren dadurch erreicht, dass einerseits die zu verbindende Schichtanordnung in einer sehr homogenen Temperaturverteilung erwärmt wird und andererseits das ganze Erwärmungssystem mit geringer thermischer Trägheit ausgeführt ist.

Die schematische Anordnung für die Herstellung eines Legierkontaktes gemäss einem bevorzugten Ausführungsbeispiel der Erfindung ist in Fig. 3 dargestellt. In diesem bewährten Ausführungsbeispiel wird die Schichtanordnung aus Halbleitersubstrat 4 und Kontaktscheibe 6 zwischen zwei parallel angeordneten Flächenheizelementen 13 und 17 derart angeordnet, dass die Fläche der stoffschlüssigen Verbindung zwischen dem Halbleitersubstrat 4 und der Kontaktscheibe 6 parallel zu den Flächen der Flächenheizelemente 13, 17 orientiert ist.

Jedes der Flächenheizelemente 13 bzw. 17 wird mit einer entsprechenden Heizleistung $P_1$ bzw. $P_2$ beaufschlagt, die dann flächenhaft in Form von Wärmestrahlung abgegeben wird. Handelt es sich bei den Flächenheizelementen 13, 17 speziell um Graphitfolien oder -platten, wird die Heizleistung mittels eines durch die Folien fliessenden Stromes eingespeist.

Um beim Legiervorgang den erforderlichen Flächenkontakt zwischen Halbleitersubstrat 4, Kontaktscheibe 6 und der dazwischenliegenden Lotschicht herzustellen und aufrechtzuerhalten, ist es zweckmässig, die Schichtanordnung mit einem Gewicht 16, z.B. einer Mo-Scheibe, zu belasten.

Damit die Anordnung aus den zunächst locker aufeinanderliegenden Scheiben ausreichend zentriert ist, ist um die Anordnung herum ein ringförmiger Halter 18 (in Fig. 3 gestrichelt eingezeichnet) vorgesehen, der vorzugsweise aus Quarzglas besteht und die Wärmestrahlung von den Flächenheizelementen 13, 17 zu den Hauptflächen ungehindert durchlässt.

Eine homogene Temperaturverteilung wird einerseits durch das Ausschliessen konvektiver Vorgänge gewährleistet: Dazu findet die Erwärmung für den Legiervorgang im Vakuum, vorzugsweise unter einem Druck von weniger als $1.10^5$ mbar bei 650°C, und ausschliesslich über den Austausch von Wärmestrahlung statt.

Andererseits ist die Schichtanordnung nur dann einer gleichmässigen Wärmestrahlung ausgesetzt, wenn die Flächen der Flächenheizelemente 13, 17 deutlich grösser gewählt werden als die Flächen der Scheiben in der Schichtanordnung. So wurden bei erfolgreichen Versuchen mit dem erfindungsgemässen Verfahren Graphitfolien mit einer Abmessung von jeweils 100 mm x 100 mm verwendet, um Halbleiterscheiben mit Durchmessern von etwa 40 bzw. 80 mm mit Legierkontakten zu versehen. Der Abstand der Graphitfolien wurde dabei ≤50 mm gewählt und kann bei grösseren Flächen entsprechend vergrössert werden.

Generell kann dazu gesagt werden, dass die Flächen der Flächenheizelemente 13, 17 wenigstens 4 mal so gross ausgelegt sein sollten wie die Fläche der Schichtanordnung bzw. Halbleiterscheibe 4. Insbesondere sollte der resultierende radiale Temperaturgradient in der Schichtanordnung kleiner als 5 K gehalten werden.

Schliesslich ist es auch besonders günstig, die Temperaturverhältnisse zwischen den Flächenheizelementen (und damit in der Schichtanordnung) genau zu regeln, und zwar vorzugsweise mit einer Genauigkeit von ±2 K.

Der gute Strahlungsaustausch zwischen Schichtanordnung und Flächenheizelementen sowie die geringe thermische Trägheit der vorzugsweise 0,2 bis 0,5 mm dicken Graphitfolien machen eine ausserordentlich präzise und rasche Temperatursteuerung und -regelung möglich. Zu Regelzwecken ist ein erster Temperaturmessfühler 14, z.B. ein NiCr-Ni-Mantelthermoelement mit 0,5 mm Durchmesser, freihängend zwischen der Schichtanordnung und dem oberen Flächenheizelement 13 vorgesehen. Eine kurze Ansprechzeit dieses ersten Temperaturmessfühlers 14 trägt zur Schnelligkeit des Regelkreises bei, welcher mit einem PID-Regler bekannter Bauart realisiert werden kann.

Die Messung der Temperatur innerhalb der Schichtanordnung erfolgt zweckmässigerweise über einen zweiten Temperaturmessfühler 15 (ein ähnliches Thermoelement wie beim ersten Temperaturmessfühler 14), der in einer tiefen radialen Bohrung im Gewicht 16 angebracht ist.

Mit einer Anordnung nach Fig. 3 wurden bei der Herstellung von Legierkontakten Aufheizraten von 20 K/min und Abkühlraten von 60 K/min im Vakuum bei Temperaturen oberhalb von 540°C erreicht. Insbesondere diese hohen Abkühlraten tragen dazu bei, den Legierprozess an der Oberfläche des Halbleitersubstrats lokal zu begrenzen.

Das beschriebene Verfahren zur Herstellung von Legierkontakten wurde bei Halbleitersubstraten aus Si mit Durchmessern bis zu 77 mm durchgeführt, die mit Kontaktscheiben aus Mo (Dicke 1-2,5 mm), welche jeweils den gleichen Durchmesser aufwiesen, stoffschlüssig verbunden wurden.

Insgesamt steht mit der Erfindung ein Verfahren zur Verfügung, mit dem Legierkontakte für Leistungshalbleiter schnell, einfach und zuverlässig hergestellt werden können, ohne flache pn-Uebergänge unterhalb der Verbindungsfläche zu gefährden.

Bei der Kontaktierung von Si-Halbleitersubstraten mit Mo-Kontaktscheiben konnten unter den beschriebenen Bedingungen Legierkontakte erzielt werden, die weniger als 10µm in das Halbleitersubstrat hineinreichten.

**Patentansprüche**

1. Verfahren zum Herstellen von Halbleiterbauelementen, insbesondere für höhere Leistungen, bei welchem Verfahren ein scheibenförmiges Halbleitersubstrat (4) auf wenigstens einer Substratseite mit einer metallischen Kontaktscheibe (6) stoffschlüssig verbunden wird, und welches Verfahren die folgenden Schritte umfasst:

(a) zwischen dem Halbleitersubstrat (4) und der damit zu verbindenden Kontaktscheibe (6) wird wenigstens eine Schicht aus einem Lot angeordnet, welches Lot mit dem Halbleitermaterial des Halbleitersubstrats (4) eine eutektische Legierung bilden kann;

(b) die Schichtanordnung aus Kontaktscheibe (6), Lotschicht und Halbleitersubstrat (4) wird auf eine Temperatur oberhalb der eutektischen Temperatur der Legierung aus Lot und Halbleitermaterial erwärmt;

dadurch gekennzeichnet, dass

(c) die Erwärmung der Schichtanordnung einzeln durch Wärmestrahlung in einem Vakuum erfolgt; und

(d) für die Erwärmung Flächenheizelemente (13, 17) verwendet werden, deren Fläche grösser ist als die Fläche der zu verbindenden Schichtanordnung.

2. Verfahren nach Anspruch 1, dadurch gekennzeichnet, dass

(a) die Schichtanordnung zwischen zwei parallel angeordneten Flächenheizelementen (13, 17) erwärmt wird, wobei

(b) die Fläche der stoffschlüssigen Verbindung zwischen dem Halbleitersubstrat (4) und der Kontaktscheibe (6) parallel zu den Flächen der Flächenheizelemente (13, 17) orientiert ist.

3. Verfahren nach Anspruch 2, dadurch gekennzeichnet, dass

(a) die Flächenheizelemente (13, 17) stromdurchflossene Graphitfolien sind;

(b) die Heizleistungen ($P_1$, $P_2$) beider Flächenheizelemente geregelt werden; und

(c) zur Regelung ein erster Temperaturmessfühler (14) zwischen einem der Flächenheizelemente (13, 17) und der Schichtanordnung vorgesehen ist.

4. Verfahren nach Anspruch 3, dadurch gekennzeichnet, dass

(a) in der Schichtanordnung das Halbleitersubstrat (4) oberhalb der Kontaktscheibe (6) angeordnet ist;

(b) die Schichtanordnung mit einem auf dem Halbleitersubstrat (4) liegenden Gewicht (16) belastet ist; und

(c) innerhalb des Gewichts (16) ein zweiter Temperaturmessfühler (15) zur Messung der Temperatur in der Schichtanordnung vorgesehen ist.

5. Verfahren nach Anspruch 4, dadurch gekennzeichnet, dass (a) das Halbleitersubstrat (4) aus Si besteht;

(b) als Lot Al verwendet wird; und

(c) die Kontaktscheibe (6) aus Mo oder W besteht.

6. Verfahren nach Anspruch 3, dadurch gekennzeichnet, dass

(a) die Graphitfolien eine Dicke zwischen 0,2 und 0,5 mm aufweisen;

(b) die geheizte Fläche der Graphitfolien wenigstens 4 mal so gross ist wie die Fläche der Schichtanordnung;

(c) das Vakuum bei 650°C besser ist als $1.10^{-5}$ mbar;

(d) die Temperatur in der Schichtanordnung mit einer Genauigkeit von $\pm 2$ K geregelt wird;

(e) der radiale Temperaturgradient in der Schichtanordnung kleiner 5 K gehalten wird; und

(f) die Schichtanordnung mittels eines ringförmigen Halters (18) aus Quarzglas zentriert wird.

## Revendications

1. Procédé pour fabriquer des composants semiconducteurs, en particulier pour des puissances élevées, procédé dans lequel un substrat semiconducteur (4) en forme de disque est matériellement assemblé à un disque de contact métallique (6), et procédé qui comprend les opérations suivantes:

entre le substrat semiconducteur (4) et le disque de contact (6) à assembler avec celui-ci est disposée au moins une couche d'un métal d'apport de brasage, lequel peut former un alliage eutectique avec le matériau semiconducteur du substrat semiconducteur (4); et

la pile de couches composée du disque de contact (6), de la couche de brasage et du substrat semiconducteur (4) est chauffée jusqu'à une température supérieure à la température d'eutectique de l'alliage composé du métal d'apport et du matériau semiconducteur,

caractérisé en ce que

le chauffage de la pile de couches est effectué uniquement par rayonnement thermique sous vide, et que

pour le chauffage, on utilise des éléments chauffants plans (13, 17), dont la surface est plus grande que la surface de la pile des couches à assembler.

2. Procédé suivant la revendication 1, caractérisé en ce que

(a) la pile de couches est chauffée entre deux éléments chauffants de surface (13, 17) disposés parallèlement,

(b) la surface de la liaison matérielle entre le substrat semiconducteur (4) et le disque de contact (6) est orientée parallèlement aux surfaces des éléments chauffants de surface (13, 17).

3. Procédé suivant la revendication 2, caractérisé en ce que

(a) les éléments chauffants de surface (13, 17) sont des feuilles de graphite parcourues par un courant;

(b) les puissances de chauffage ($P_1$ $P_2$) des deux éléments chauffants de surface sont régulées; et

(c) pour la régulation, il est prévu une première sonde de température (14) entre un des éléments chauffants de surface (13, 17) et la pile de couches.

4. Procédé suivant la revendication 3, caractérisé en ce que

(a) dans la pile de couches le substrat semiconducteur (4) est disposé au-dessus du disque de contact (6);

(b) la pile de couches est chargée par un poids (16) posé sur le substrat semiconducteur (4); et

(c) à l'intérieur du poids (16) est prévue une seconde sonde de température (15) pour mesurer la température dans la pile de couches.

5. Procédé suivant la revendication 4, caractérisé en ce que

(a) le substrat semiconducteur (4) se compose de Si;

(b) on utilise Al comme métal d'apport de brasage; et

(c) le disque de contact (6) se compose de Mo ou de W.

6. Procédé suivant la revendication 3, caractérisé en ce que

(a) les feuilles de graphite présentent une épaisseur comprise entre 0,2 et 0,5 mm;

(b) la face chauffée des feuilles de graphite est au moins 4 fois plus grande que la surface de la pile de couches;

(c) le vide à 650°C est inférieur à $1.10^{-5}$ mbar;

(d) la température dans la pile de couches est régulée avec une précision de $\pm 2$ K;

(e) le gradient de température radial dans la pile de couches est maintenu inférieur à 5 K; et

(f) la pile de couches est centrée au moyen d'un support en forme de bague (18) en verre quartzeux.

## Claims

1. A method for manufacturing semiconductor components, in particular those of higher power, in which method a wafer-shaped semiconductor substrate (4) on at least one substrate side is materially bonded to a metal contact wafer (6), and which method comprises the following steps:

(a) arranging between the semiconductor substrate (4) and the contact wafer (6) to be bonded thereto at least one layer of a solder, which solder can form a eutectic alloy with the semiconductor material of the semiconductor substrate (4); and

(b) heating the layer arrangement of contact wafer (6), solder layer and semiconductor substrate (4) to a temperature above the eutectic temperature of the alloy of solder and semiconductor material; wherein

(c) the heating of the layer arrangement takes place individually through thermal radiation in a vacuum; and

(d) the heating is effected with panel heating elements (13, 17) whose area is larger than the area of the layer arrangement to be bonded.

2. The method as claimed in claim 1, wherein

(a) the layer arrangement is heated between two parallel panel heating elements (13, 17),

(b) the plane of the material bond between the semiconductor substrate (4) and the contact wafer (6) being orientated parallel to the surfaces of the panel heating elements (13, 17).

3. The method as claimed in claim 2, wherein

(a) the panel heating elements (13, 17) are current-carrying graphite sheets;

(b) the heating powers ($P_1$, $P_2$) of the two panel heating elements are regulated; and

(c) for the purposes of regulation a first temperature sensor (14) is provided between one of the panel heating elements (13, 17) and the layer arrangement.

4. The method as claimed in claim 3, wherein

(a) in the layer arrangement the semiconductor substrate (4) is located above the contact layer (6);

(b) the layer arrangement is loaded with a weight (16) lying on the semiconductor substrate (4); and

(c) within the weight (16) a second temperature sensor (15) is provided for measuring the temperature in the layer arrangement.

5. The method as claimed in claim 4, wherein

(a) the semiconductor substrate (4) is composed of Si.

(b) A1 is used as solder and

(c) the contact wafer (6) is composed of Mo or W.

6. The method as claimed in claim 3, wherein

(a) the graphite sheets have a thickness of between 0.2 and 0.5 mm;

(b) the heated area of the graphite sheets is at least 4 times as large as the area of the layer arrangement;

(c) the vacuum at 650°C is better than $1 \times 10^{-5}$ mbar;

(d) the temperature in the layer arrangement is regulated with an accuracy of $\pm 2$ K;

(e) the radial temperature gradient in the layer arrangement is kept smaller than 5 K; and

(f) the layer arrangement is centered by means of a ring-shaped holder (18) of quartz glass.

FIG.1

FIG.2

FIG.3